# EUROPEAN PATENT APPLICATION

(11) **EP 3 886 151 A1**
(43) Date of publication of application: **29.09.2021**
(21) Application number: 21160663.7
(22) Date of filing: 04.03.2021
(51) Int. Cl.: H01L 21/78

(54) **METHOD FOR FORMING A PACKAGED SEMICONDUCTOR DEVICE**

(30) Priority: 24.03.2020 US 202016828115
(71) Applicant: NXP B.V., 5656 AG Eindhoven (NL)
(72) Inventor: MOELLER, Sascha, Redhill, Surrey RH1 1QZ (GB); ALBERMANN, Guido, Redhill, Surrey RH1 1QZ (GB); ZERNACK, Michael, Redhill, Surrey RH1 1QZ (GB)
(74) Representative: Hardingham, Christopher Mark

(57) **Abstract**

A semiconductor wafer having a plurality of die is attached to a support structure. The semiconductor wafer includes an active layer over a silicon layer, wherein the active layer is at a top side, and a bottom side exposes the silicon layer. While the wafer is attached to the support structure, an infrared laser beam is focused through a portion of the silicon layer to create a modification region along saw lanes located between neighboring die of the plurality of die. Afterwards, a metal layer is formed on the exposed silicon layer at the bottom side of the semiconductor wafer. The metal layer is attached to an expansion tape, and the wafer is singulated by extending the expansion tape to separate the die of the plurality of die along the saw lane. A first singulated die of the plurality of die is packaged to form a packaged semiconductor device.

## Description

### Background

### Field

This disclosure relates generally to integrated circuits, and more specifically, to a method for forming a packaged semiconductor device.

### Related Art

In forming packaged semiconductor devices, a semiconductor wafer is first singulated into a plurality of die. These die are then packaged, using a variety of packaging types. Sawing using a saw blade is commonly used to singulate wafers, however, such sawing may damage the die during singulation, such as resulting in chip outs on the front side or back side of the die. Furthermore, many wafers require processing on both the front and back sides, therefore, any chipping or damage can adversely affect both sides of the wafer.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIGs. 1 - 7 illustrate, in cross section form, various processing stages for singulating a wafer, in accordance with one embodiment of the present invention.
FIG. 8 illustrates, in cross section form, a package singulated die, in accordance with one embodiment of the present invention.
FIGs. 9 and 10 illustrate various views of stealth laser dicing, in accordance with one embodiment of the present invention.
FIG. 11 illustrates a top down view of a wafer, prior to singulation, in accordance with one embodiment of the present invention.

### Detailed Description

In one aspect, rather than sawing, stealth laser dicing is used to singulate die in a wafer. Stealth dicing is performed by focusing an infrared (IR) laser along saw lines from the backside of the wafer into the thickness of the semiconductor material of the wafer, between the top and bottom surfaces of the wafer. This results in modification of mono crystalline silicon to poly crystalline, creating a stress zone in the wafer and resulting in pre-cracks along the saw lines of the wafer. However, it is not possible to process such an IR laser through certain materials, such as metal or other IR blocking films. Therefore, in one aspect, after the formation of the pre-cracks along the saw lines of the wafer, further processing is performed on the backside of the wafer, such as backside metallization. After completion of this processing, the wafer is singulated along the saw lines, using the previously formed pre-cracks, in which the singulation entirely separates each die along with any corresponding backside layers or films.

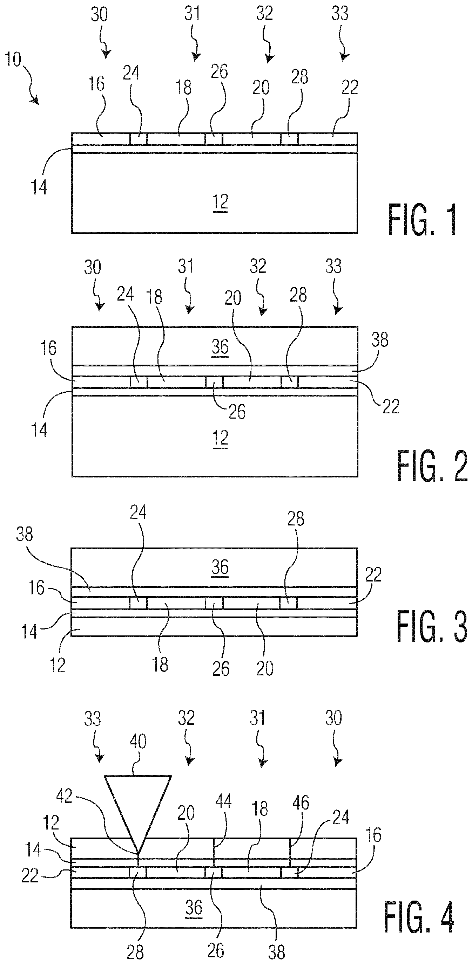

FIG. 1 illustrates, in cross-section form, a semiconductor wafer 10, in accordance with one embodiment of the present invention. The cross-section of wafer 10 includes four die 30-33. In alternate embodiments, as will be described below, the cross-section of wafer 10 may include any number of die. At the top side (also referred to as the front side), wafer 10 includes an active layer 14 overlying a silicon layer 12. Silicon layer 12 may be formed of mono crystalline silicon, and active layer 14 includes active circuitry for each die as well as metal layers. The active circuitry may be any type of circuitry to perform any type of functions, as needed in each die. A passivation layer is located over the top surface of wafer 10, such as passivation layers 16, 18, 20, and 22 on the top surfaces of each of die 31-33, respectively. The passivation layer may have openings therein, as needed, to expose contact pads of the die. Between each die, there is a region designated as a saw lane (also referred to as a saw street). These include saw lane 24 between die 30 and 31, saw lane 26 between die 31 and 32, and saw lane 28 between die 31 and 32. Active layer 14 may include metal layers in the saw lanes as well, such as test structures or other fabrication features, which will be destroyed upon wafer singulation. It is desirable to make these saw lanes as narrow as possible in order to fill the wafer area with more die space.

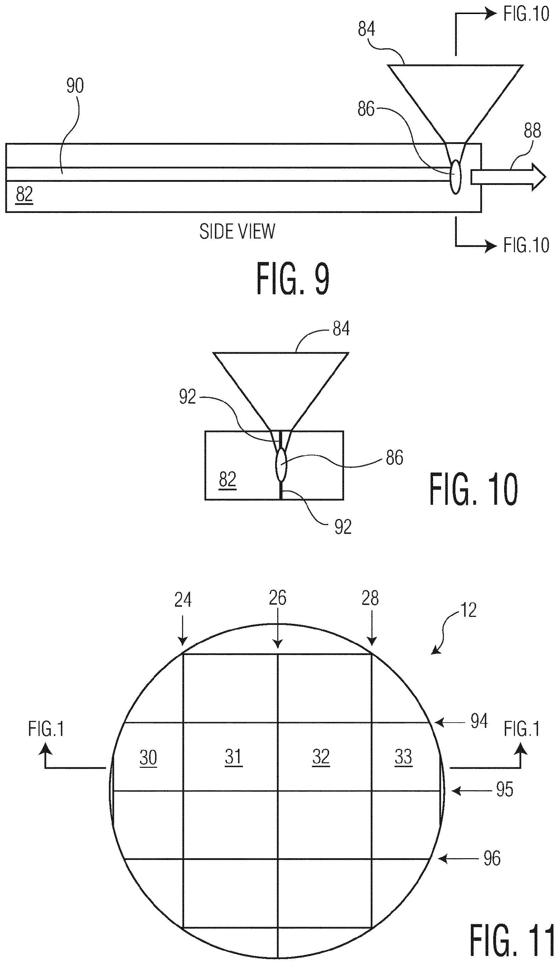

FIG. 11 illustrates a top down view of wafer 10, in accordance with one embodiment of the present invention. In the embodiment of FIG. 11, wafer 10 includes twelve die, however, in alternate embodiments, wafer 10 includes any number of die, depending on the size of each die and the total surface area of the wafer. Also visible in FIG. 11 are the vertical and horizontal saw lanes located between each die. The saw lanes (also referred to as saw streets) refer to the lines along which the die of wafer 10 will be singulated. The vertical saw lanes includes saw lanes 24, 26, and 28, which are also visible in the cross-section of FIG. 1. The horizontal saw lanes include saw lanes 94, 95, and 96. Saw lane 94 is located at the top boundary of die 30-33 and is not visible in the cross-section of FIG. 1 as it would be located behind the page. Similarly, saw lane 95 is located at the bottom boundary of die 30-33 and is also not visible in the cross-section of FIG. 1 as it would be located immediately in front of the page. In general, all the saw lanes have the same width, corresponding to the width visible in FIG. 1 between passivation layers of neighboring die.

FIG. 2 illustrates wafer 10 of FIG. 1 at a subsequent stage in processing, in accordance with one embodiment of the present invention. In FIG. 2, a supporting plate 36 (also referred to as a support structure) is bonded to the top side of wafer 10. An adhesive layer 38 is used to attach supporting plate 36 to the top surface of wafer 10. In one embodiment, supporting plate 36 is a glass carrier. However, in alternate embodiments, other materials or structures may be used. In one embodiment, the supporting plate has a thickness in a range of approximately 800 to 1000 micrometer. As will be described below, the supporting plate supports the wafer to ensure that the die are protected and stay together in wafer form through subsequent processing.

FIG. 3 illustrates wafer 10 at a subsequent stage in processing, in accordance with one embodiment of the present invention. In FIG. 3, the bottom side of wafer 10 (also referred to as the back side), opposite the top side which includes active layer 14, is thinned (such as by grinding) so as to result in a target thickness for wafer 10. This target thickness can be any thickness, depending on customer needs. In one embodiment, active layer 14 has a thickness in a range of approximately 6 to 12 micrometers, while silicon layer 12 has a resulting thickness of about 50 micrometers.

FIG. 4 illustrates wafer 10 at a subsequent stage in processing. In FIG. 4, wafer 10 is flipped such that the exposed side of supporting plate 36 is placed on a carrier or other support structure. For example, in one embodiment, the exposed side of supporting plate 36 is attached or mounted to a dicing tape with a supporting ring (such as a film frame carrier (FFC)). Laser stealth dicing is then applied to create a modification region along the saw lanes of wafer 10, which results in the formation of micro pre-cracks in the saw lanes of wafer 10. As illustrated in FIG. 4, a focused IR laser beam 40 is applied to the exposed back side of wafer 10 to create pre-cracks 42, 44, and 46 along the saw lanes of wafer 10, such as saw lanes 24, 26, and 28, respectively. These micro pre-cracks extend through or mostly through silicon layer 12 of wafer 10, and correspond to where the die separations will occur during singulation.

FIGs. 9 and 10 illustrate various views of laser stealth dicing to form the micro pre-cracks. FIG. 9 illustrates a cross-sectional side view of a saw lane in a silicon layer 82. That is, in FIG. 9, the saw lane runs between the right and left sides of the page. Silicon layer 82 corresponds to the silicon layer of a wafer, such as silicon layer 12 of wafer 10. An IR laser beam 84 is focused through layer 82 to about the middle of layer 82 (the middle between the top and bottom of layer 82) resulting in a modification region 86 in which the mono crystalline silicon of layer 82 is converted into poly crystalline silicon. Laser beam 84 can be scanned from left to right, as illustrated in FIG. 9 by arrow 88. As it is scanned, a modification layer 90 is formed from all the modification regions which result as the laser is moved along the saw lane. Therefore, note that the modification regions or modification layer is parallel to the top and bottom surfaces of the silicon layer in which it is formed (e.g. layer 82). Therefore, while layer 82 is mono crystalline silicon, modification layer 90 is poly crystalline silicon. The modification layer 90 creates a stress zone, which results in a pre-crack 92 extending above and below modification layer 90, as illustrated in the front view of FIG. 10. Therefore, from modification region 86, a pre-crack 92 results which extends above and below the modification region. It is desirable that pre-crack 92 extend through the entire thickness of layer 82. These pre-cracks run along the length of modification layer 90, and correspond, for example, to pre-cracks 42, 44, and 46 of FIG. 4. Laser 84 is scanned along all the saw lanes of wafer 10 such that a modification layer is formed along saw lanes 24, 26, 28, 94, 95, and 96 (seen in FIG. 11). It is desirable that all the resulting pre-cracks from the modification layer extend through the entire thickness of silicon layer 12.

In one embodiment, if silicon layer 12 is too thick, a scan with an IR laser at more than one depth may be performed. For example, rather than focusing laser beam 84 in the middle of layer 82, laser beam 84 can be focused at a first depth into layer 82, above the bottom of layer 82, and scanned a first time. Then laser beam 84 can be focused at a second depth into layer 82, above the first depth but below the top of layer 82, and scanned a second time. These two scans, for a first time and a second time, respectively, would be performed along all the saw lanes of wafer 10. In yet other embodiments, additional scans may be done at different depths, depending on the thickness of the silicon layer, in order to sufficiently form the pre-cracks through a full thickness of the layer.

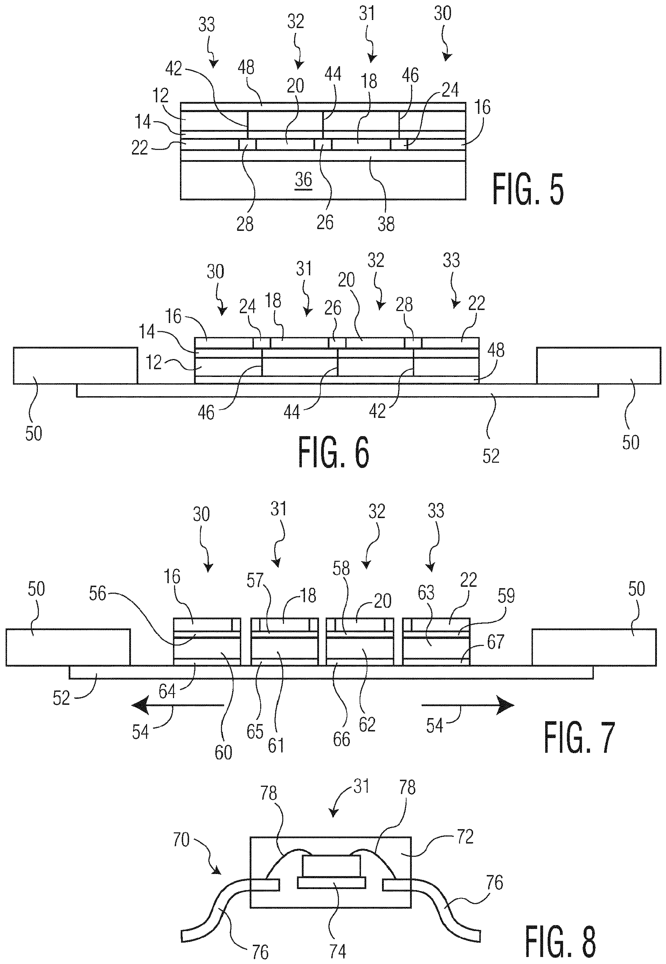

Note that the laser scan of FIG. 5 is performed through the exposed silicon layer 12 of the backside of wafer 10. There is no intervening or IR blocking layer formed on the backside of wafer 10 so that laser beam 40 can be correctly focused into a middle portion of layer 12. In one embodiment, the laser beam may be applied through the front side of wafer 10 (assuming supporting plate 36 is instead attached to the backside of wafer 10). However, the saw lanes may be too narrow to allow for beam 40 to focus at a correct depth into silicon layer 12 without affecting active circuitry of neighboring die. Also, as discussed above, there may be metal layers formed in the saw lane areas between the die, also hindering the proper focusing of laser beam 40. Therefore, in one embodiment, it is desirable to perform the stealth dicing directly through the exposed silicon layer at the backside of wafer 10.

FIG. 5 illustrates wafer 10 at a subsequent stage in processing. After the stealth dicing, the supporting ring and the dicing tape (or other support structure) is removed from supporting plate 36 and wafer 10. Note that supporting plate 36 ensures that the die of wafer 10 remain in wafer form and do not break apart at the previously formed pre-cracks along the saw lanes. Subsequently, further back side processing may be performed in which one or more layers or films may be formed on or applied to the back side of wafer 10, opposite the top side of wafer 10. For example, in the illustrated embodiment of FIG. 5, a back side metal layer 48 is formed on the back side of wafer 10, in which metal layer 48 is formed over the pre-cracks within layer 12. That is, the pre-cracks in wafer 10 are located between the top side of wafer 10 and metal layer 48. In one embodiment, metal layer 48 is formed with a sputtering process.

FIG. 6 illustrates wafer 10 at a subsequent stage in processing. After formation of any back side layers, such as back side metal layer 48, wafer 10 is run through a wafer expansion process to singulate the die. For the expansion process, an expansion tape 52 with a support ring 50 (such as an FFC) is provided. Wafer 10 is flipped and mounted onto expansion tape 52 within ring 50, back side down, such that back side metal layer 48 is attached to expansion tape 52. After mounting wafer 10 to expansion tape 52, supporting plate 36 and adhesive 38 are removed from the front side of wafer 10.

FIG. 7 illustrates wafer 10 at a subsequent stage in processing. Wafer 10 is extended by pulling expansion tape 52 in all directions equally, as illustrated by arrows 54. Note that the tape will also be pulled in directions into and out of the page. This pulling of extension tape 52 results in separating all die of wafer 10 equally apart from each other. Since back side metal layer 48 is very thin (in a range, for example, of 1 to 3 micrometers), it cannot withstand the pulling force and therefore wafer 10 cracks apart at the same places as the micro pre-cracks which were previously formed in silicon layer 12 by IR laser beam 40. In this manner, the die of wafer 10, such as die 30-33, are all singulated without damage to the top and bottom surfaces of the die. By waiting to form any back side metal layers until after creation of micro pre-cracks by way of stealth dicing, stealth dicing can still be successfully used to singulate die having a back side metal layer and thus greatly reduce the risk of damaging the front or back sides of the die during singulation. A back side metal layer may be desirable for a die for heat dissipation (such as in power or radio frequency (RF) devices), power absorption and transfer through the silicon, or to change the capacitive factor of the device, or combinations thereof.

Note that the stealth dicing modifies mono crystalline into poly crystalline silicon but does not result in the removal of any of the silicon material. This is in contrast to forming grooves or trenches along the saw lanes for improved singulation. The grooves or trenches require further processing and may also require wider saw lanes. Therefore, through the use of stealth dicing, note that narrower saw lanes can be used as compared to other singulation methods such as blade dicing or those methods requiring the formation of grooves or trenches in the saw lanes.

FIG. 8 illustrates a packaged semiconductor device having a singulated die from wafer 10. After singulation of wafer 10, a pick and place tool may select each die and provide it for further processing, which may include semiconductor packaging. The example of FIG. 8 illustrates a lead frame package 70 in which singulated die 31 is placed on a flag portion 74 of a lead frame, wire bonds 78 are formed to provide connections between die 31 and leads 76 of the lead frame. The package is then incapsulated with encapsulant 72. Any known packaging technology may be used, and is not limited to lead frames.

Therefore, by now it can be appreciated how die with back side metal can be singulated using stealth dicing to result in singulated die having less damage, in general, than die singulated with a blade process. Each singulated die can then be packaged. This singulation may result in higher die yield from each wafer, and thus higher yield of packaged semiconductor devices from each wafer.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Moreover, the terms "front," "back," "top," "bottom," "over," "under", "front side", "back side" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. For example, different types of packages can be made using the singulated die. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention.

In one embodiment, a method for forming a packaged semiconductor device includes attaching a semiconductor wafer having a plurality of die to a support structure, wherein the semiconductor wafer includes an active layer over a silicon layer, wherein the active layer is at a top side of the semiconductor wafer, and a bottom side of the semiconductor wafer, opposite the top side, exposes the silicon layer. While the semiconductor wafer is attached to the support structure, an infrared laser beam is focused through a portion of the silicon layer to create a modification region within the silicon layer along saw lanes located between neighboring die of the plurality of die. After the creating the modification region, a metal layer is formed on the exposed silicon layer at the bottom side of the semiconductor wafer, such that the modification region and semiconductor layer is between the active layer and the metal layer. The method further includes attaching the metal layer to an expansion tape; singulating the semiconductor wafer by extending the expansion tape to separate the die of the plurality of die along the saw lanes; and packaging a first singulated die of the plurality of die to form a packaged semiconductor device. In one aspect of the above embodiment, the method further includes after the attaching the metal layer to the expansion tape and prior to the singulating, removing the support structure. In another aspect, the method further includes, prior to the focusing the infrared laser beam through the portion of the silicon layer, thinning the exposed silicon layer. In a further aspect, thinning the silicon layer includes grinding the bottom side of the semiconductor wafer. In another aspect of the above embodiment, the focusing the infrared laser beam includes scanning the focused infrared laser beam along the saw lanes to create the modification region within the silicon layer along the saw lanes and parallel to the top and bottom surfaces of the silicon layer. In a further aspect, the method further includes scanning a second infrared laser beam through a second portion of the silicon layer to create a second modification region in the silicon layer along the saw lanes and parallel to the top and bottom surfaces of the silicon layer, wherein the first modification region is located between the second modification region and the active layer. In another aspect, the creation of the modification region results in micro pre-cracks in the silicon layer along the saw lanes. In a further aspect, the singulating the semiconductor wafer by extending the expansion tape to separate the die of the plurality of die along the saw lanes is performed such that the die of the plurality of die are separated along the previously created micro pre-cracks in the silicon layer. In a further aspect, the micro pre-cracks extend through a full thickness of the silicon layer along the saw lanes. In another aspect of the above embodiment, after creation of the modification region, the modification region includes poly crystalline silicon and the silicon layer outside the modification region includes mono crystalline silicon. In yet another aspect, the support structure includes a glass carrier. In yet another aspect, the semiconductor wafer includes a passivation layer over the active layer, such that the active layer is between the passivation layer and the silicon layer. In yet another aspect, the forming the metal layer includes sputtering the metal layer on the exposed silicon layer at the bottom side of the semiconductor wafer.

In another embodiment, a method for forming a packaged semiconductor device includes attaching a top side of a semiconductor wafer having a plurality of die to a support structure, wherein the semiconductor wafer includes saw lanes between neighboring die of the plurality of die and includes an active layer over a silicon layer, wherein the active layer is at the top side of the semiconductor wafer, and while the semiconductor wafer is attached to the support structure, using an infrared laser beam to create micro pre-cracks in the silicon layer along the saw lanes of the semiconductor wafer. After the creating the micro pre-cracks, while the semiconductor wafer is attached to the support structure, a metal layer is formed on an exposed surface of the silicon layer at a bottom side of the semiconductor wafer, opposite the top side of the semiconductor wafer, such that the micro pre-cracks extend through a thickness of the silicon layer, between the active layer and the metal layer. The method further includes attaching the metal layer to an expansion tape and removing the support structure; singulating the semiconductor wafer by extending the expansion tape to separate the die of the plurality of die along the micro pre-cracks in the saw lanes; and packaging a first singulated die of the plurality of die to form a packaged semiconductor device. In one aspect of the another embodiment, the forming the metal layer includes sputtering the metal on the exposed surface of the silicon layer. In another aspect, using the infrared laser to from the micro pre-cracks includes applying the infrared layer to create a modification region in the silicon layer by converting mono crystalline silicon of the silicon layer to poly crystalline silicon, wherein the creation of the modification region results in micro pre-cracks in the silicon layer. In a further aspect, creating the modification region includes applying the infrared laser beam to the exposed surface of the silicon layer on the bottom side of the semiconductor wafer along the saw lanes such that the modification region is created part way through a thickness of the silicon layer. In another further aspect, the modification region is created between a top surface and a bottom surface of the silicon layer. In another further aspect, the micro pre-cracks extend through a full thickness of the silicon layer between the active layer and the metal layer.

In yet another embodiment, a method for forming a packaged semiconductor device, includes attaching a semiconductor wafer having a plurality of die to a support structure, wherein the semiconductor wafer includes an active layer over a mono crystalline silicon layer, wherein the active layer is at a top side of the semiconductor wafer, and a bottom side of the semiconductor wafer, opposite the top side, exposes the mono crystalline silicon layer. While the semiconductor wafer is attached to the support structure, an infrared laser beam is applied through the mono crystalline silicon layer to create a poly crystalline silicon modification region along saw lanes located between neighboring die of the plurality of die, wherein the poly crystalline silicon modification region is created between a top surface and a bottom surface of the mono crystalline silicon layer. After the creating the poly crystalline silicon modification region and while the semiconductor wafer is attached to the support structure, a metal layer is formed on the exposed mono crystalline silicon layer at the bottom side of the semiconductor wafer, such that the poly crystalline modification region is between the active layer and the metal layer. The method further includes attaching the metal layer to an expansion tape such that the metal layer is between the expansion tape and the mono crystalline silicon layer; after the attaching the metal layer, removing the support structure; singulating the semiconductor wafer by extending the expansion tape to separate the die of the plurality of die along the saw lanes; and packaging a first singulated die of the plurality of die to form a packaged semiconductor device.

## Claims

1. A method for forming a packaged semiconductor device, the method comprising:
attaching a semiconductor wafer having a plurality of die to a support structure, wherein the semiconductor wafer includes an active layer over a silicon layer, wherein the active layer is at a top side of the semiconductor wafer, and a bottom side of the semiconductor wafer, opposite the top side, exposes the silicon layer;
while the semiconductor wafer is attached to the support structure, focusing an infrared laser beam through a portion of the silicon layer to create a modification region within the silicon layer along saw lanes located between neighboring die of the plurality of die;
after the creating the modification region, forming a metal layer on the exposed silicon layer at the bottom side of the semiconductor wafer, such that the modification region and semiconductor layer is between the active layer and the metal layer;
attaching the metal layer to an expansion tape;
singulating the semiconductor wafer by extending the expansion tape to separate the die of the plurality of die along the saw lanes; and
packaging a first singulated die of the plurality of die to form a packaged semiconductor device.

2. The method of claim 1, further comprising:
after the attaching the metal layer to the expansion tape and prior to the singulating, removing the support structure.

3. The method of claim 1 or 2, further comprising:
prior to the focusing the infrared laser beam through the portion of the silicon layer, thinning the exposed silicon layer.

4. The method of claim 3, wherein thinning the silicon layer comprises grinding the bottom side of the semiconductor wafer.

5. The method of any preceding claim, wherein the focusing the infrared laser beam comprises scanning the focused infrared laser beam along the saw lanes to create the modification region within the silicon layer along the saw lanes and parallel to the top and bottom surfaces of the silicon layer.

6. The method of claim 5, further comprising:
scanning a second infrared laser beam through a second portion of the silicon layer to create a second modification region in the silicon layer along the saw lanes and parallel to the top and bottom surfaces of the silicon layer, wherein the first modification region is located between the second modification region and the active layer.

7. The method of any preceding claim, wherein the creation of the modification region results in micro pre-cracks in the silicon layer along the saw lanes.

8. The method of claim 7, wherein the singulating the semiconductor wafer by extending the expansion tape to separate the die of the plurality of die along the saw lanes is performed such that the die of the plurality of die are separated along the previously created micro pre-cracks in the silicon layer.

9. The method of claim 7 or 8, wherein the micro pre-cracks extend through a full thickness of the silicon layer along the saw lanes.

10. The method of any preceding claim, wherein after creation of the modification region, the modification region comprises poly crystalline silicon and the silicon layer outside the modification region comprises mono crystalline silicon.

11. The method of any preceding claim, wherein the support structure comprises a glass carrier.

12. The method of any preceding claim, wherein the semiconductor wafer comprises a passivation layer over the active layer, such that the active layer is between the passivation layer and the silicon layer.

13. The method of any preceding claim wherein the forming the metal layer comprises sputtering the metal layer on the exposed silicon layer at the bottom side of the semiconductor wafer.
